(19) **Europäisches Patentamt European Patent Office Office européen des brevets**

(11) **EP 2 357 496 B1**

(12) **FASCICULE DE BREVET EUROPEEN**

(45) Date de publication et mention
de la délivrance du brevet:
**05.09.2012 Bulletin 2012/36**

(51) Int Cl.:
***G01T 1/26*** (2006.01)     ***H01L 27/146*** (2006.01)
***H01L 31/115*** (2006.01)

(21) Numéro de dépôt: **10197019.2**

(22) Date de dépôt: **27.12.2010**

(54) **Dispositif imageur pixelisé intégré à transduction par diamant et procédé de réalisation**

Bildaufnahmevorrichtung mit Pixeln, die mit einem Diamant basierten Detektor integriert ist, und ihr
Herstellungsverfahren

Pixelated imaging device integrated with a diamond-based detector and its manufacturing process

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.12.2009 FR 0959670**

(43) Date de publication de la demande:
**17.08.2011 Bulletin 2011/33**

(73) Titulaire: **Commissariat à l'Énergie Atomique
et aux Énergies Alternatives
75015 Paris (FR)**

(72) Inventeur: **Mazellier, Jean-Paul
51100 Reims (FR)**

(74) Mandataire: **Ilgart, Jean-Christophe et al
BREVALEX
95 rue d'Amsterdam
75378 Paris Cedex 8 (FR)**

(56) Documents cités:
**US-A- 5 352 897**

- **LAGOMARSINO S ET AL: "New perspectives of
the Silicon-On-Diamond material", 9TH
INTERNATIONAL CONFERENCE ON LARGE
SCALE APPLICATIONS AND RADIATION
HARDNESS OF SEMICONDUCTOR MATERIALS,
FLORENCE, ITALY, 30 septembre 2009
(2009-09-30), XP002591611,**
- **WIDIEZ J ET AL: "Fabrication of Silicon on
Diamond (SOD) substrates by either the Bonded
and Etched-back SOI (BESOI) or the Smart-Cut
technology", SOLID STATE ELECTRONICS,
ELSEVIER SCIENCE PUBLISHERS, BARKING,
GB LNKD- DOI:10.1016/J.SSE.2009.12.012, vol.
54, no. 2, 21 décembre 2009 (2009-12-21), pages
158-163, XP026904429, ISSN: 0038-1101 [extrait
le 2010-02-01]**

Printed by Jouve, 75001 PARIS (FR)

**Description**

**DOMAINE TECHNIQUE**

L'invention concerne le domaine des dispositifs imageurs permettant de détecter et/ou de mesurer un rayonnement de photons et/ou de particules à haute énergie, par exemple des rayonnements de photons à haute énergie de type X, UV, gamma, et/ou des rayonnements de particules à haute énergie de type alpha ou de neutrons.

L'invention trouve des applications dans de nombreux domaines techniques tels que le nucléaire, l'imagerie médicale, l'imagerie de contrôle ou encore l'imagerie spatiale.

**ÉTAT DE LA TECHNIQUE ANTÉRIEURE**

Le diamant est un matériau connu pour ses propriétés de détection de rayonnement de photons et/ou de particules de haute énergie. Ainsi, certains dispositifs de détection de photons et/ou de particules de haute énergie utilisent du diamant en tant que matériau transducteur pour réaliser une telle détection : les photons et/ou les particules à haute énergie reçus, formant le signal d'intérêt, interagissent avec le réseau cristallin du diamant en générant des paires électron-trou avec une énergie caractéristique par interaction de 13 eV.

Les porteurs électriques créés sont alors collectés au niveau d'électrodes métalliques du dispositif de détection, créant entre les électrodes un signal électrique représentatif du rayonnement reçu de photons et/ou des particules à haute énergie.

Selon la structure des électrodes, il est possible de déduire du signal électrique mesuré entre les électrodes l'énergie des entités (photons ou particules) du signal d'intérêt, l'intensité du rayonnement reçu et, lorsque le détecteur est un détecteur pixélisé, c'est-à-dire comportant plusieurs pixels formés à partir du diamant, la modulation spatiale du signal d'intérêt, le signal électrique mesuré entre les électrodes de chaque pixel constituant dans ce cas l'image du signal d'intérêt pour le pixel en question.

Plusieurs contraintes sont à prendre en considération pour réaliser un détecteur pixélisé :

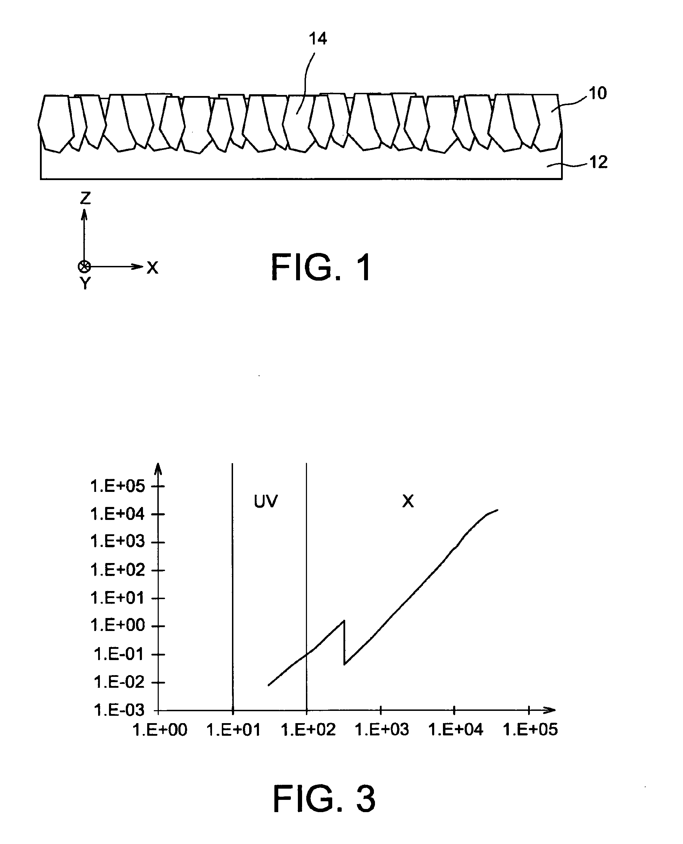

- étant donné que chaque pixel doit être associé à une sortie (chaque pixel délivrant un signal électrique), il se pose généralement des problèmes d'encombrement liés à la connectique nécessaire pour récupérer les signaux de chaque pixel,
- pour augmenter la résolution du détecteur, il faut à la fois diminuer la taille des électrodes et conserver un rapport signal/bruit des mesures acceptable. Or, ces deux contraintes sont antagonistes,
- pour des détecteurs de grande taille (par exemple supérieure à environ 1 mm$^2$), il est nécessaire d'utiliser du diamant synthétique, par exemple de type CVD (déposé chimiquement en phase vapeur). Or, le diamant synthétique est généralement formé sur un hétérosubstrat, c'est-à-dire un substrat à base d'un matériau autre que du diamant, ce qui implique, compte tenu du procédé de croissance mis en oeuvre pour former le diamant, que le diamant comporte une structure granulaire avec une évolution des grains dans le sens de l'épaisseur du matériau (formant une couche de diamant de type colonnaire). La figure 1 représente une telle couche de diamant polycristallin CVD 10 formée sur un substrat 12. Comme on peut le voir sur cette figure 1, la couche de diamant 10 est formée par une multitude de grains 14 comportant chacun une base (partie se trouvant du côté du substrat 12) de dimensions inférieures, dans le plan (X,Y), aux dimensions du reste du grain. La forme des grains peut être assimilée grossièrement à un cône. Or, la base des grains 14 qui est la partie de la couche de diamant 10 formée au début de la croissance du diamant, c'est-à-dire celle se trouvant contre le substrat 12, est généralement défectueuse électriquement et participe au bruit intrinsèque du dispositif imageur formé à partir de la couche de diamant 10.

Le document de R. Stone et al., intitulé "CVD Diamond Pixel Development", IEEE TRANSACTIONS ON NUCLEAR SCIENCE, VOL. 49, No. 3, Juin 2002, décrit un détecteur comprenant une couche de diamant CVD disposée entre plusieurs électrodes avant (une pour chaque pixel) et une électrode arrière commune à tous les pixels. Les électrodes avant sont couplées à un circuit électronique de lecture, permettant de lire les signaux électriques délivrés sur les électrodes avant, par l'intermédiaire de microbilles de soudure (« bumping ») .

Un tel dispositif présente toutefois plusieurs inconvénients :

- la taille minimale des électrodes est limitée par celle des microbilles qui est importante (par exemple égale à environ 125 μm),
- les microbilles engendrent une surépaisseur dans le dispositif,
- l'homogénéité des réponses électriques obtenues sur les différentes électrodes, c'est-à-dire dans les différents pixels, n'est pas assurée à cause de variations électriques pouvant être engendrées par les microbilles,
- le rendement, d'un point de vue temps et coût, pour la réalisation de ces microbilles n'est pas bon,
- le report de la couche de diamant sur le circuit électronique de lecture implique des étapes de manipulation de cette couche, qui est fine, pouvant entrainer une détérioration du diamant.

Le document de LAGOMARSINO S. et al. « New perspectives of the Silicon-On-Diamond material », 9th International conference on large scale applications and radiation hardness of semiconductor materials, Florence, Italie, 30 septembre 2009, décrit un dispositif imageur comportant plusieurs pixels, chaque pixel comprenant :

- une portion d'une couche de diamant disposée entre une première et une seconde électrode, et apte à réaliser la transduction d'un rayonnement de photons et/ou de particules en un signal électrique,
- un circuit électronique de lecture du signal électrique, relié électriquement à la première électrode et réalisé dans une portion d'une couche de matériau semi-conducteur formant la couche superficielle de silicium d'un substrat de type SOD comportant également la couche de diamant.

## EXPOSÉ DE L'INVENTION

Un but de la présente invention est de proposer un dispositif imageur pixélisé apte à détecter et/ou mesurer un rayonnement de photons et/ou de particules à haute énergie qui ne présente pas les inconvénients de l'art antérieur tout en tenant compte des contraintes liées à un dispositif imageur pixélisé, et qui, notamment, ne présente pas les inconvénients liés à l'utilisation de microbilles pour solidariser une structure de détection à base de diamant utilisée pour la transduction du rayonnement mesuré et/ou détecté avec un circuit électronique.

Pour cela, la présente invention concerne un dispositif imageur tel que défini dans la revendication 1.

Le dispositif imageur selon l'invention fait donc appel à une couche de diamant physiquement liée à une couche de semi-conducteur, ces deux couches formant ainsi un bloc unique.

La couche de diamant du substrat SOD sert de transducteur convertissant le signal d'intérêt (photons et/ou particules de haute énergie) en un signal électrique, la couche de semi-conducteur permettant de réaliser le circuit électronique servant à amplifier et/ou lire le signal électrique issu de la couche de diamant.

Les caractéristiques du signal électrique délivré par le circuit électronique peuvent alors être reliées à celles du rayonnement reçu dans la couche de diamant.

Dans le dispositif selon l'invention, la couche de diamant peut jouer le rôle de bouclier et empêcher le rayonnement de photons et/ou de particules à haute énergie de venir détériorer le circuit électronique. Par exemple, lorsque le dispositif reçoit des rayonnements de particules $\alpha$, la couche de diamant peut avoir une épaisseur supérieure ou égale à environ 15 µm, assurant ainsi la protection du circuit électronique.

De plus, contrairement à un semi-conducteur tel que du silicium, le diamant possède un numéro atomique faible, se traduisant par une faible interaction du diamant avec les rayonnements de haute énergie de type UV et X mous.

Etant donné que le diamant présente une faible réponse aux rayonnements visibles par rapport aux rayonnements à hautes énergies (« solar blind » en anglais), il n'y a donc pas besoin de retravailler les images obtenues avec le dispositif imageur selon l'invention pour corriger les phénomènes parasites, par exemple lors d'une imagerie spatiale.

Un tel dispositif peut également être utilisé pour contrôler en temps réel certaines caractéristiques d'un rayonnement traversant le dispositif, par exemple pour des applications de radiothérapie (rayonnement de photons X). Pour de telles applications, le dispositif peut donc être réalisé tel que chacun des éléments du dispositif soit faiblement absorbant. On pourra dans ce cas choisir de réaliser le dispositif avec une couche de diamant d'épaisseur inférieure ou égale à environ la longueur d'absorption du diamant qui est définie en fonction de l'énergie des photons reçus, et à réaliser les interconnexions métalliques du dispositif par exemple à base d'aluminium (matériau semi-transparent aux rayons X) .

Ce dispositif peut également être utilisé pour détecter les particules alpha, notamment dans des applications de surveillance de neutrons dans lesquelles une source de neutrons est utilisée pour irradier l'objet à étudier (une remorque de camion par exemple). Un écran est dans ce cas placé après l'objet étudié. Pour corréler le signal obtenu sur l'écran au signal de départ dont les caractéristiques sont inconnues, on peut utiliser les particules de type alpha issues du processus de génération des neutrons.

En effet, chaque neutron est associé une particule alpha avec un moment parfaitement opposé (propagation dans la direction opposée). La corrélation du signal de neutrons et du signal relatif aux particules de type alpha (mesure par temps de vol) permet alors de remonter à la structure initiale de l'objet étudié. L'épaisseur de la couche de diamant peut dans ce cas être égale à environ 10 µm.

Ce dispositif imageur peut également être utilisé en tant que détecteur de neutrons à haute énergie, le diamant présentant une meilleure tenue à ce type de rayonnement que le silicium ou un autre composé de numéro atomique élevé.

Le substrat de type SOD comporte en outre une couche diélectrique disposée entre la couche de diamant et le circuit électronique. Une telle couche diélectrique permet notamment de protéger la couche de diamant des flux d'oxygène à hautes températures utilisés lors de la réalisation du circuit électronique, tout en assurant une isolation électrique entre le diamant et le semi-conducteur du circuit électronique. Cette isolation électrique permet donc une meilleure gestion des importantes tensions appliquées sur le dispositif, et évite des problèmes de fonctionnement liés à ces tensions.

La couche de matériau semi-conducteur a une épaisseur inférieure ou égale à environ 1 µm. Une telle épaisseur permet de limiter les interactions entre le semi-conducteur et le rayonnement reçu, de réduire les risques de dégradation du circuit électronique ainsi que l'apparition de signaux électriques erronés aux bornes des électrodes. Cette couche mince permet également de faciliter la réalisation de l'électrode supérieure et de maximiser la collecte du signal électrique.

Le circuit électronique peut également comporter un ou plusieurs transistors de type PD-SOI ou FD-SOI.

L'utilisation d'une couche de matériau semi-conducteur d'épaisseur inférieure ou égale à environ 1 μm permet de réaliser un circuit électronique comportant des dispositifs, par exemple des transistors CMOS, à basse consommation et résistants aux rayonnements de photons et/ou de particules à haute énergie. En effet, en minimisant l'épaisseur de la couche de matériau semi-conducteur, on limite les effets d'interaction du semi-conducteur avec le rayonnement reçu, réduisant les risques d'une éventuelle dégradation du circuit électronique et l'apparition de signaux électriques erronés aux bornes des électrodes du dispositif.

La première électrode et le circuit électronique peuvent être disposés côte à côte au niveau d'une première face de la couche de diamant. On entend par « côte à côte » le fait que la projection d'une section de la première électrode dans le plan passant par la première face de la couche de diamant ne se superpose pas à la projection d'une section du circuit électronique dans ce même plan. Autrement dit, la première électrode et le circuit électronique ne sont pas superposés l'un au-dessus de l'autre.

Dans ce cas, la première électrode peut comporter des parois latérales au moins partiellement recouvertes par au moins un matériau diélectrique, lesdites parois latérales pouvant être sensiblement perpendiculaires à une paroi inférieure de la première électrode disposée contre la première face de la couche de diamant.

Ce matériau diélectrique peut ainsi isoler électriquement le matériau électriquement conducteur de l'électrode du matériau semi-conducteur dans lequel le circuit électronique est réalisé et qui se trouve à côté de l'électrode.

Le dispositif imageur peut comporter en outre des moyens de filtrage aptes à absorber des rayonnements de longueurs d'ondes comprises entre environ 380 nm et 780 nm disposés en regard d'une seconde face, opposée à la première face, de la couche de diamant. De tels moyens de filtrage permettent ainsi de protéger le circuit électronique de rayonnements de photons dans le domaine visible, et éviter ainsi que ces rayonnements provoquent un dysfonctionnement du circuit électronique.

Dans une variante, la première électrode peut être disposée contre la couche de diamant, et entre le circuit électronique et la couche de diamant.

Ainsi, dans cette configuration, la première électrode du dispositif imageur est disposée sous le circuit électronique, ce qui permet d'obtenir un gain de place dans le dispositif.

La couche de diamant peut comporter une partie de nucléation se trouvant au niveau de sa première face, la première électrode pouvant être en partie disposée dans un creux formé dans la partie de nucléation de la couche de diamant. Cette configuration permet ainsi d'éviter que la première électrode soit en contact avec la partie de nucléation de la couche de diamant, améliorant l'homogénéité du contact électrique entre le diamant et la première électrode.

Dans une variante, la couche de diamant peut comporter une partie de nucléation se trouvant au niveau d'une face opposée à celle contre laquelle est disposée la première électrode. Cette variante permet d'avoir la partie de nucléation de la couche de diamant du côté opposé à celui où se trouve la première électrode.

Le dispositif peut comporter en outre au moins une couche de passivation recouvrant au moins le circuit électronique qui est relié électriquement à la première électrode par l'intermédiaire d'au moins une portion d'une couche d'interconnexions électriques disposée sur la couche de passivation et de vias traversant réalisés à travers au moins la couche de passivation et reliant électriquement ladite portion de la couche d'interconnexion électrique au circuit électronique et à la première électrode. Le terme « via traversant » désigne un trou d'interconnexion rempli par un matériau électriquement conducteur.

L'invention concerne également un procédé de réalisation d'un dispositif imageur comportant plusieurs pixels, comprenant, pour chaque pixel, au moins les étapes de :

- réalisation, dans une portion d'une couche de matériau semi-conducteur, cette couche ayant une épaisseur inférieure ou égale à environ 1 μm et formant la couche superficielle d'un substrat de type SOD comportant également une couche de diamant, d'un circuit électronique d'amplification et/ou de lecture de signal électrique, le substrat comportant également une couche diélectrique disposée entre la couche de diamant et le circuit électronique,
- réalisation d'une première électrode telle qu'une portion de la couche de diamant soit disposée entre la première électrode et une seconde électrode, et soit apte à réaliser la transduction d'un rayonnement de photons et/ou de particules en un signal électrique,
- réalisation d'une liaison électrique au moins entre la première électrode et le circuit électronique.

La réalisation de la première électrode peut être obtenue au moins par la mise en oeuvre des étapes suivantes :

a) dépôt d'une couche de passivation recouvrant le circuit électronique et la couche de matériau semi-conducteur,

b) réalisation, dans la couche de passivation et la couche de matériau semi-conducteur, et à côté du circuit électronique, d'une cavité,

c) dépôt d'une couche diélectrique au moins contre les parois de la cavité,

d) gravure d'une partie de la couche diélectrique formant une paroi de fond de la cavité, révélant une partie d'une première face de la couche de diamant,
e) réalisation d'une portion de matériau électriquement conducteur disposée dans la cavité, contre la première face de la couche de diamant, formant la première électrode.

Dans une variante, la réalisation de la première électrode peut être obtenue au moins par la mise en oeuvre des étapes suivantes :

a) réalisation, dans la couche de matériau semi-conducteur, et à côté du circuit électronique, d'une cavité,
b) dépôt d'une couche diélectrique au moins contre les parois de la cavité,
c) gravure d'une partie de la couche diélectrique formant une paroi de fond de la cavité, révélant une partie d'une première face de la couche de diamant,
d) réalisation d'une portion de matériau électriquement conducteur disposée dans la cavité, contre la première face de la couche de diamant, formant la première électrode,
e) dépôt d'une couche de passivation recouvrant la première électrode, le circuit électronique et la couche de matériau semi-conducteur.

La couche diélectrique peut être disposée entre la première face de la couche de diamant et la couche de matériau semi-conducteur, et dans lequel l'étape d) de gravure ou l'étape a) de réalisation de la cavité peut également réaliser la gravure d'une partie de ladite couche diélectrique disposée au niveau de la paroi de fond de la cavité.

La couche de diamant peut comporter une partie de nucléation se trouvant au niveau de sa première face, et l'étape c) ou d) de gravure peut également réaliser la gravure d'une partie de nucléation de la couche de diamant se trouvant dans la cavité.

Le substrat de type SOD peut comporter une couche à base d'un matériau électriquement conducteur disposée entre la couche de matériau semi-conducteur et la couche de diamant, la réalisation de la première électrode pouvant être obtenue au moins par la mise en oeuvre d'une gravure de la couche de matériau semi-conducteur et de la couche de matériau électriquement conducteur selon un motif conforme à celui de la première électrode, la première électrode pouvant être disposée contre la couche de diamant et entre le circuit électronique et la couche de diamant.

La couche diélectrique peut être disposée entre la couche de matériau électriquement conducteur et la couche de matériau semi-conducteur, et, au cours de la réalisation de la première électrode, la couche diélectrique peut être également gravée selon un motif conforme à celui de la première électrode, telle que la première électrode soit disposée contre la couche de diamant et entre une portion restante de la couche diélectrique et la couche de diamant.

Le procédé de réalisation peut comporter en outre la mise en oeuvre, entre la réalisation de la première électrode et la réalisation de la liaison électrique, d'une étape de dépôt d'une couche de planarisation recouvrant au moins le circuit électronique et la première électrode.

La réalisation de la liaison électrique entre la première électrode et le circuit électronique peut être obtenue au moins par la mise en oeuvre des étapes suivantes :

f) réalisation de vias traversant reliés électriquement à la première électrode et au circuit électronique au moins à travers la couche de passivation,
g) réalisation d'une couche d'interconnexions électriques sur la couche de passivation, telle qu'au moins une portion de la couche d'interconnexions électriques et les vias traversant relient électriquement la première électrode au circuit électronique.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- la figure 1 représente une couche de diamant polycristallin CVD formée sur un substrat,
- les figures 2A à 2H représentent les étapes d'un procédé de réalisation d'un dispositif imageur, objet de la présente invention, selon un premier mode de réalisation,

- la figure 3 représente la longueur d'absorption d'une couche de diamant du dispositif imageur, objet de la présente invention, en fonction de l'énergie des photons destinés à être détectés par le dispositif imageur,
- la figure 4 représente le diamètre des grains d'une couche de diamant polycristallin d'un dispositif imageur, objet de la présente invention, en fonction de l'épaisseur de la couche de diamant,
- la figure 5 représente l'efficacité quantique effective d'une couche de diamant CVD polycristallin d'un dispositif imageur, objet de la présente invention, en fonction de la longueur d'onde du rayonnement incident arrivant sur ce diamant,
- la figure 6 représente un dispositif imageur, objet de la présente invention, selon une variante du premier mode de réalisation,
- les figures 7A à 7E représentent les étapes d'un procédé de réalisation d'un dispositif imageur, objet de la présente invention, selon un second mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

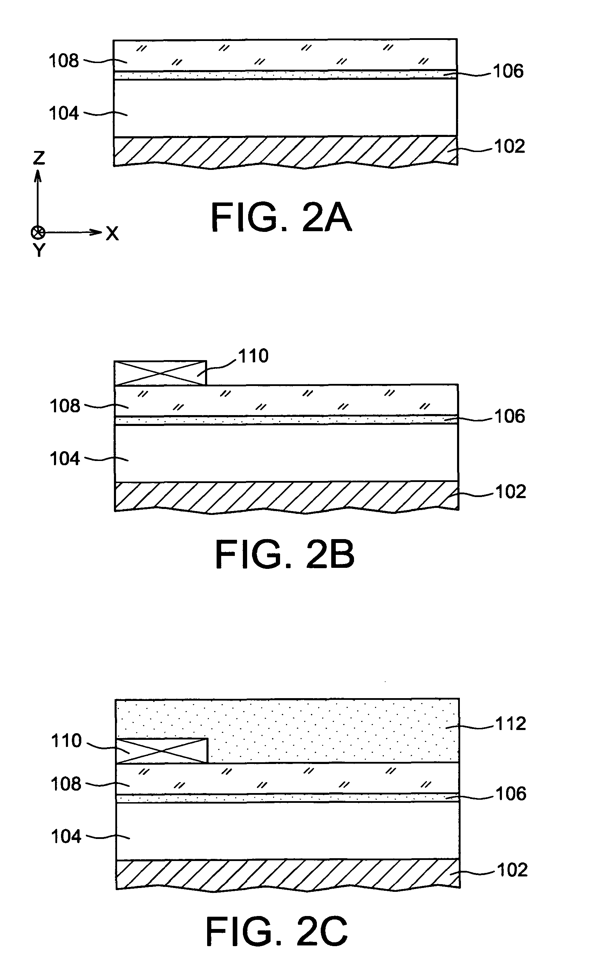

On se réfère tout d'abord aux figures 2A à 2H qui représentent les étapes d'un procédé de réalisation d'un dispositif imageur 100 de rayonnement selon un premier mode de réalisation. Sur ces figures 2A à 2H, seule la réalisation d'une partie du dispositif imageur 100, correspondant à un pixel du dispositif imageur 100, est représentée.

Comme représenté sur la figure 2A, on réalise le dispositif imageur 100 à partir d'un substrat de type SOD, c'est-à-dire de type semi-conducteur sur diamant, comportant une couche arrière 102, une couche de diamant 104, une couche barrière 106 et une couche superficielle 108 à base de semi-conducteur, ici du silicium.

La couche de diamant 104 est disposée entre la couche arrière 102 et la couche barrière 106, et la couche barrière 106 est disposée entre la couche de diamant 104 et la couche superficielle 108 à base de silicium.

La couche superficielle 108 est une couche mince d'épaisseur inférieure ou égale à environ 1 $\mu$m. La couche barrière 106 est à base d'un matériau diélectrique, tel que de l'oxyde de semi-conducteur ou du nitrure de semi-conducteur, et a par exemple une épaisseur comprise entre environ 100 nm et 1 $\mu$m.

La couche arrière 102 peut être à base d'un matériau électriquement conducteur. Dans ce cas, la couche arrière 102 peut être directement utilisée en tant qu'électrode arrière du dispositif imageur 100.

Toutefois, la couche arrière 102 peut également être utilisée en tant que support lors de la réalisation du dispositif imageur 100, et être par exemple à base de semi-conducteur. Dans ce cas, la couche arrière 102 est, à la fin du procédé, remplacée par une couche électriquement conductrice, par exemple une couche métallique. Il est également possible, lorsque la couche arrière 102 est à base d'un matériau semi-conducteur, de réaliser un dopage de celle-ci afin de la rendre électriquement conductrice, celle-ci formant alors l'électrode arrière du dispositif. On veillera toutefois à préalablement amincir la couche arrière 102 afin que celle-ci ait par exemple une épaisseur inférieure ou égale à environ 1 $\mu$m afin de ne pas perturber le flux.

Bien que cela ne soit pas visible sur la figure 2A, la couche de diamant 104, qui comporte une structure granulaire similaire à la couche de diamant 10 représentée sur la figure 1, comporte une partie de nucléation se trouvant du côté de la surface à partir de laquelle la croissance du diamant a été réalisée.

Cette partie de nucléation peut se trouver soit du côté de la couche arrière 102, soit du côté de la couche barrière 106. Lorsque le diamant de la couche 104 est un diamant polycristallin, cette partie de nucléation est souvent très défectueuse en raison d'un nombre important de joints de grains, de graphite, etc.

Ces joints de grains représentent un facteur de réduction du signal électrique collecté lorsqu'un rayonnement de photons et/ou de particules à haute énergie est reçu dans la couche de diamant 104, en raison d'interactions apparaissant entre les porteurs électriques créés et les joints de grain. Ainsi, le procédé décrit en liaison avec les figures 2A à 2H est de préférence mis en oeuvre à partir d'un substrat SOD dont la couche de diamant 104 comporte une partie de nucléation se trouvant du côté de la couche arrière 102 et non du côté de la couche barrière 106 afin de limiter la réduction du signal électrique collecté.

Le diamant de la couche 104 peut être de type polycristallin CVD (déposé chimiquement en phase vapeur), HOD (diamant fortement orienté) ou encore du type monocristallin intrinsèque.

L'épaisseur de la couche de diamant 104 sera choisie notamment en fonction du type de rayonnement que le dispositif imageur 100 est destiné à détecter. En effet, la longueur d'absorption dans le diamant de la couche 104 est fonction de l'énergie des photons du rayonnement reçu dans le diamant.

La courbe représentée sur la figure 3 correspond à la longueur d'absorption du diamant, en $\mu$m, en fonction de l'énergie des photons reçus, en eV, ici dans le domaine des rayons UV et X.

L'épaisseur de la couche de diamant 104 peut donc être choisie supérieure ou égale à la longueur d'absorption des photons et/ou particules destinées à être détectées par le dispositif imageur 100. Toutefois, pour des raisons de facilité de réalisation, il est possible que l'épaisseur de la couche de diamant 104 soit inférieure à cette longueur d'absorption, ce qui peut avoir pour conséquence de laisser passer une partie du rayonnement reçu.

Les étapes de réalisation d'un tel substrat SOD sont connues de l'état de la technique et ne sont donc pas détaillée ici.

On réalise ensuite, à partir de la couche de semi-conducteur 108 et pour chaque pixel, un circuit électronique 110 formant ici un amplificateur du signal électrique qui sera collecté aux bornes des électrodes du pixel lorsqu'un rayonnement de photons et/ou de particules sera reçu dans la portion de diamant du pixel (figure 2B).

Ce circuit électronique 110 est par exemple similaire à un circuit d'amplification d'un capteur de type CCD (à couplage de charge) ou CMOS. Lorsque la couche superficielle 108 est une couche mince d'épaisseur inférieure ou égale à environ 1 μm, le circuit électronique 110 peut comporter des éléments, par exemple des transistors, de type PD-SOI, c'est-à-dire à déplétion partielle, ou FD-SOI, c'est-à-dire à déplétion totale. Ainsi, en minimisant l'épaisseur de la couche superficielle 108, on limite les effets d'interaction du semi-conducteur de la couche superficielle 108 avec les photons et/ou les particules à haute énergie envoyés dans la couche de diamant 104, réduisant ainsi les risques d'une possible dégradation du circuit électronique 110 et l'apparition d'erreurs dans le signal électrique collecté.

Lors de la réalisation du circuit électronique 110, des flux d'oxygène à hautes températures traversent la couche superficielle 108, par exemple lors d'une étape d'oxydation du semi-conducteur de la couche superficielle 108.

Le matériau diélectrique de la couche barrière 106 protège la couche de diamant 104 et la couche arrière 102 de ces flux d'oxygène qui, en l'absence de la couche barrière 106, entraineraient une combustion du diamant et dégraderaient de manière irréversible la couche de diamant 104.

Comme représenté sur la figure 2C, une première couche de passivation 112 est ensuite déposée sur le circuit électronique 110 ainsi que sur le reste de la couche superficielle de semi-conducteur 108. Une gravure partielle de la première couche de passivation 112 et de la couche superficielle de semi-conducteur 108 est ensuite mise en oeuvre afin de former, dans ces deux couches, une cavité 114 destinée à recevoir l'une des électrodes du dispositif imageur 100.

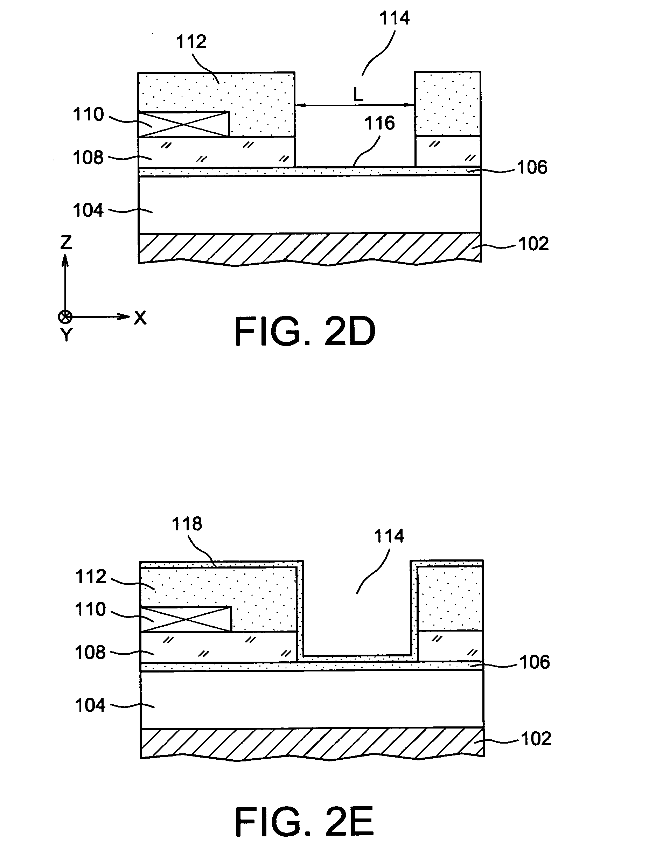

La section de cette cavité 114, dans le plan (X, Y), a ici une forme sensiblement carrée. Cette gravure permet notamment de mettre à nue une partie 116 de la surface de la couche barrière 106 (figure 2D).

Le choix des dimensions de la cavité 114, correspondant aux dimensions de l'électrode destinée à être réalisée dans la cavité 114, est réalisé en fonction de l'épaisseur de la couche de diamant 104. En effet, le diamant de la couche 104 est polycristallin, et donc par nature non homogène (dimensions variables des grains). Toutefois, le caractère homogène du diamant est évalué à l'échelle de la taille des électrodes du dispositif imageur 100, car si le diamant est homogène d'une électrode à l'autre, les pixels du dispositif imageur 100 auront des réponses relativement similaires pour un même rayonnement reçu. Ainsi, la dimension L d'un côté d'une électrode (dimension dans le plan (X,Y) représentée sur la figure 2D) du dispositif imageur 100 peut être choisie telle que $L = 5 \times D \times \sqrt{\pi}$, avec D : diamètre d'un grain de diamant.

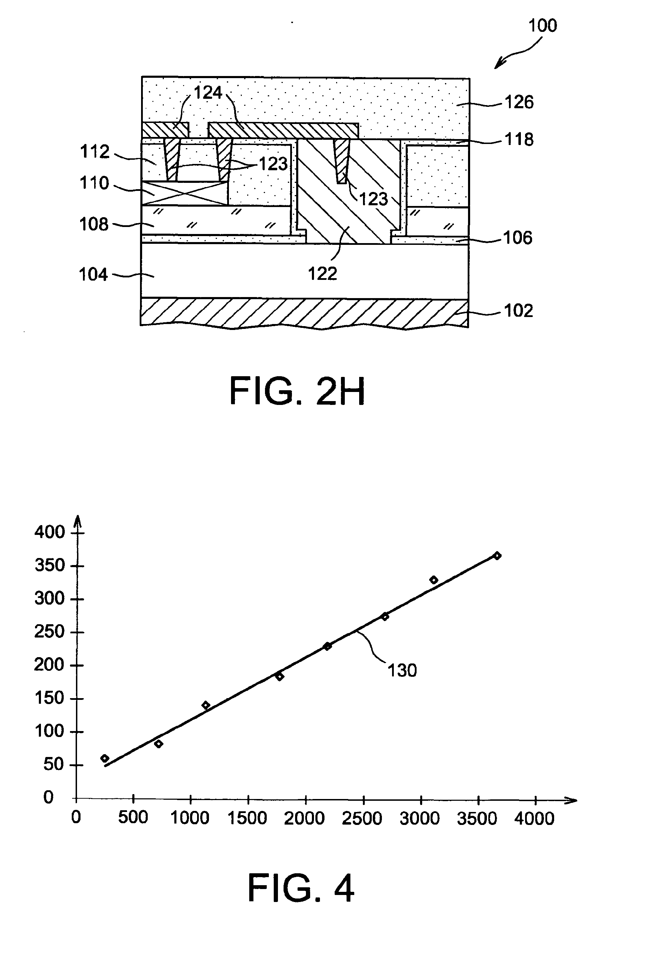

La droite 130 représentée sur la figure 4 correspond à l'évolution du diamètre des grains de diamant (en nm) en fonction de l'épaisseur (en nm) de la couche de diamant 104. On voit, à partir de la droite 130, que le diamètre D des grains de diamant évolue linéairement en fonction de l'épaisseur H de la couche de diamant 104 telle que : D = A*H + B.

La dimension minimum d'une électrode pourra être choisie sensiblement égale à l'épaisseur de la couche de diamant. Par exemple, pour une couche de diamant d'épaisseur égale à environ 3,5 μm, la dimension L minimum d'une électrode pourra être égale à environ 3,2 μm. Le choix des dimensions des électrodes sera toutefois réalisé en prenant en compte d'autres considérations, telles que la quantité minimum de signal à obtenir pour une électrode, la faisabilité technologique de réalisation d'électrodes de tailles réduites, etc. Ainsi, d'une manière générale, les dimensions de l'électrode peuvent être choisies telles qu'environ une centaine de grains soient présents sous l'électrode d'un pixel du dispositif imageur 100, permettant ainsi de maximiser l'homogénéité de réponse du dispositif imageur 100.

Afin d'isoler électriquement le semi-conducteur de la couche superficielle 108 de l'électrode destinée à être réalisée dans la cavité 114, on dépose une couche diélectrique 118 sur la première couche de passivation 112 et sur les parois de la cavité 114, recouvrant ainsi les parois latérales de la cavité 114 ainsi que la partie 116 de la surface de la couche barrière 106 formant la paroi de fond de la cavité 114 (figure 2E).

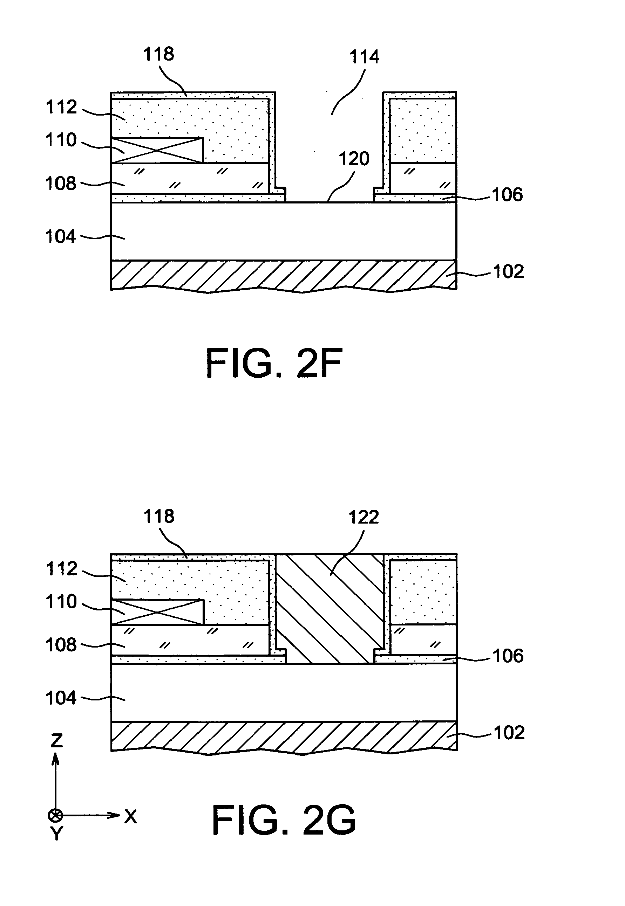

Comme représenté sur la figure 2F, on réalise ensuite une gravure de portions de la couche diélectrique 118 et de la couche barrière 106 se trouvant au niveau de la paroi de fond de la cavité 114, révélant une partie 120 de la surface de la couche de diamant 104 qui forme alors la paroi de fond de la cavité 114. Lorsque le substrat SOD utilisé pour réaliser le dispositif imageur 100 comporte une couche de diamant 104 comprenant une partie de nucléation se trouvant du côté de la couche barrière 106 (partie de nucléation se trouvant alors du côté de la paroi de fond de la cavité 114), il est possible de réaliser une gravure partielle de la couche de diamant 104 afin supprimer la partie de nucléation de la couche de diamant 104 formant la paroi de fond de la cavité 114.

Ainsi, cette suppression de la partie de nucléation au niveau de l'électrode de contact destinée à être formée dans la cavité 114 permettra d'augmenter la distance de collection des charges générées dans le diamant, et ainsi améliorer les performances électriques du dispositif imageur 100.

Pour réaliser cette suppression de la partie de nucléation de la couche de diamant au niveau de la paroi de fond de la cavité 114, il convient toutefois de s'assurer que l'épaisseur restante de diamant soit suffisante pour que celui-ci réalise l'absorption souhaitée des photons et/ou particules à haute énergie tout en conservant son homogénéité sous l'électrode, et cela afin d'éviter de rendre certaines régions de la couche de diamant de bien meilleure qualité que d'autres, ce qui aurait pour effet de dégrader la réponse du système en termes d'homogénéité.

On réalise ensuite un dépôt d'un matériau électriquement conducteur, par exemple un matériau carboné (carbure, graphite, diamant dopé) ou métallique, dans la cavité 114 et sur la couche diélectrique 118. Cette couche électriquement conductrice est ensuite planarisée pour former une électrode 122 (figure 2G). Cette planarisation est par exemple obtenue en réalisant une CMP (polissage mécano-chimique) de la couche électriquement conductrice en se servant de la couche diélectrique 118 comme couche d'arrêt.

On réalise ensuite des vias traversant 123 à base d'un matériau électriquement conducteur à travers la couche de passivation 112 et la couche diélectrique 118, et dans l'électrode 122, pour venir contacter électriquement le circuit électronique 110 et l'électrode 122. Ensuite, une couche d'interconnexions électriques 124, par exemple à base d'aluminium et/ou de tout autre matériau électriquement conducteur adapté, est formée sur la couche de passivation 112, permettant de relier électriquement, grâce aux vias 123 précédemment réalisés, l'électrode 122 au circuit électronique 110. La couche d'interconnexions électriques 124 est enfin recouverte par une seconde couche de passivation 126 (figure 2H).

Lorsque la couche arrière 102 est à base d'un matériau électriquement conducteur, celle-ci peut être conservée afin de former l'électrode arrière du dispositif imageur 100 qui est par exemple commune à tous les pixels du dispositif imageur 100. Par contre, si la couche arrière 102 est à base d'un matériau non électriquement conducteur, elle est alors remplacée par une couche électriquement conductrice formant l'électrode arrière du dispositif imageur 100.

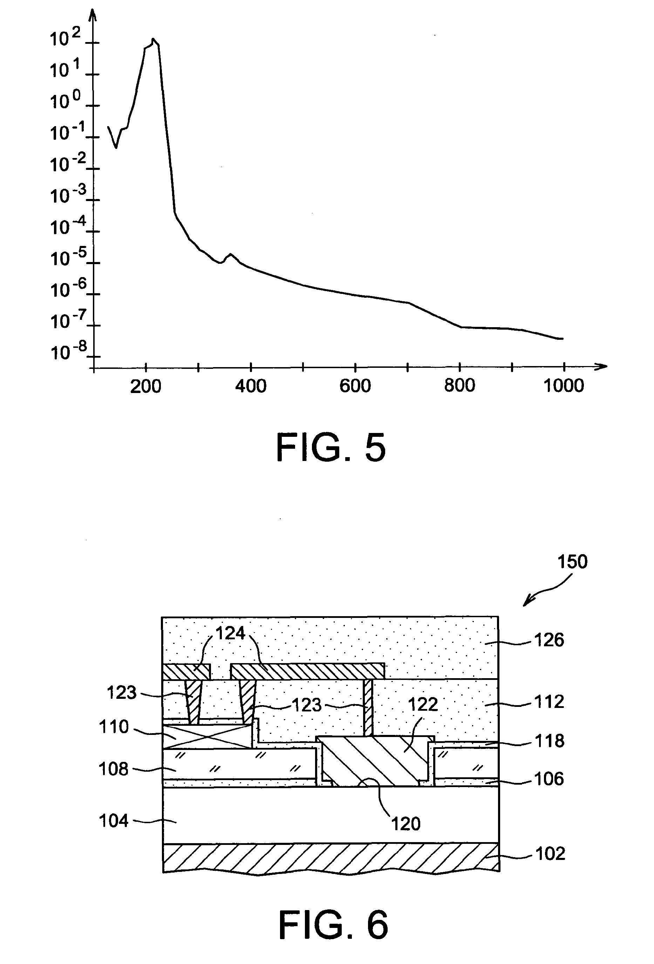

Dans ce dispositif imageur 100, le diamant de la couche 104 disposée entre l'électrode 122 et l'électrode arrière (formée par la couche arrière 102 dans l'exemple décrit sur la figure 2H) forme donc un bon transducteur générant des porteurs électriques lorsque le diamant reçoit un rayonnement de photons et/ou de particules à haute énergie. En effet, contrairement au silicium, le diamant a la propriété de présenter un fort taux de réjection de la lumière visible et infrarouge comme le montre la figure 5 sur laquelle est représentée graphiquement l'efficacité quantique effective, c'est-à-dire le nombre d'électrons générés par le rayonnement incident sur une couche de diamant CVD polycristallin, en fonction de la longueur d'onde du rayonnement reçu, exprimée en nm, pour un champ électrique de polarisation E = 28 KV/cm appliqué entre les électrodes du dispositif imageur 100.

Dans le dispositif imageur 100, les champs caractéristiques de polarisation peuvent être égaux à environ 1 V/$\mu$m dans la zone de résistivité forte du diamant.

Il conviendra donc de réaliser la polarisation du dispositif imageur 100 sur l'électrode arrière plutôt que sur l'électrode 122 afin d'éviter que le circuit électronique 110 soit exposé à des tensions élevées.

Bien que non représenté sur la figure 2H, le circuit électronique 110 du dispositif imageur 100 est relié électriquement à d'autres circuits électroniques de lecture et de traitement permettant d'appliquer diverses fonctions de traitement sur les signaux électriques amplifiés par les circuits électroniques réalisés dans le dispositif imageur 100.

Ainsi, le circuit électronique 110 amplifie le signal provenant de la couche de diamant 104 et le transmet, soit par CCD (transfert de charges au circuit de lecture extérieur), soit par lecture matricée dans le cas d'un circuit électronique 110 de type CMOS, à un circuit de lecture externe au dispositif imageur 100, réduisant ainsi l'apparition de bruit extrinsèque à la mesure et augmentant le rapport signal/bruit pour une taille d'électrode donnée. Dans une variante, il est possible que le circuit électronique 110 du dispositif imageur 100 ne réalise pas que l'amplification du signal électrique généré dans la couche de diamant, mais également une lecture de ce signal, voir même d'autres fonctions de traitement selon la place disponible sur le dispositif imageur 100.

Bien que non représenté sur la figure 2H, le dispositif imageur 100 peut comporter un filtre disposé devant la couche arrière 102, permettant de filtrer le rayonnement dans le domaine visible et éviter ainsi que le rayonnement visible traverse la couche de diamant 104 et vienne interagir avec le circuit électronique 110 et perturber son fonctionnement.

La figure 6 représente un dispositif imageur 150 selon une variante de réalisation du dispositif imageur 100 précédemment décrit.

La réalisation du dispositif imageur 150 est obtenue en mettant en oeuvre tout d'abord les étapes précédemment décrites en liaison avec les figures 2A et 2B, afin d'obtenir le circuit électronique 110 formé sur la couche de semi-conducteur 108 elle-même disposée sur la couche barrière 106, la couche de diamant 104 et la couche arrière 102.

On réalise ensuite une gravure des couches 108 et 106 afin de former une cavité destinée à recevoir l'une des électrodes du dispositif imageur 150. La couche diélectrique 118 est ensuite déposée dans cette cavité ainsi que sur le circuit électronique 110 et sur les portions de la couche 108 se trouvant à côté de la cavité. On grave ensuite une portion de la couche diélectrique 118 se trouvant au fond de la cavité afin de révéler la partie 120 de la surface de la couche de diamant 104 qui forme alors une paroi de fond de la cavité.

L'électrode 122 est ensuite réalisée, par exemple par le dépôt d'un matériau électriquement conducteur et par gravure de ce matériau, l'électrode 122 étant disposée dans la cavité en contact avec la partie 120 de la couche de diamant 104.

On dépose ensuite la couche de passivation 112 sur l'ensemble des éléments précédemment réalisés. Enfin, de manière analogue au dispositif imageur 100, on réalise les vias traversant 123, la couche d'interconnexions électriques 124, puis la seconde couche de passivation 126.

Par rapport au dispositif imageur 100, ce dispositif imageur 150 a pour avantage d'être plus simple à réaliser technologiquement.

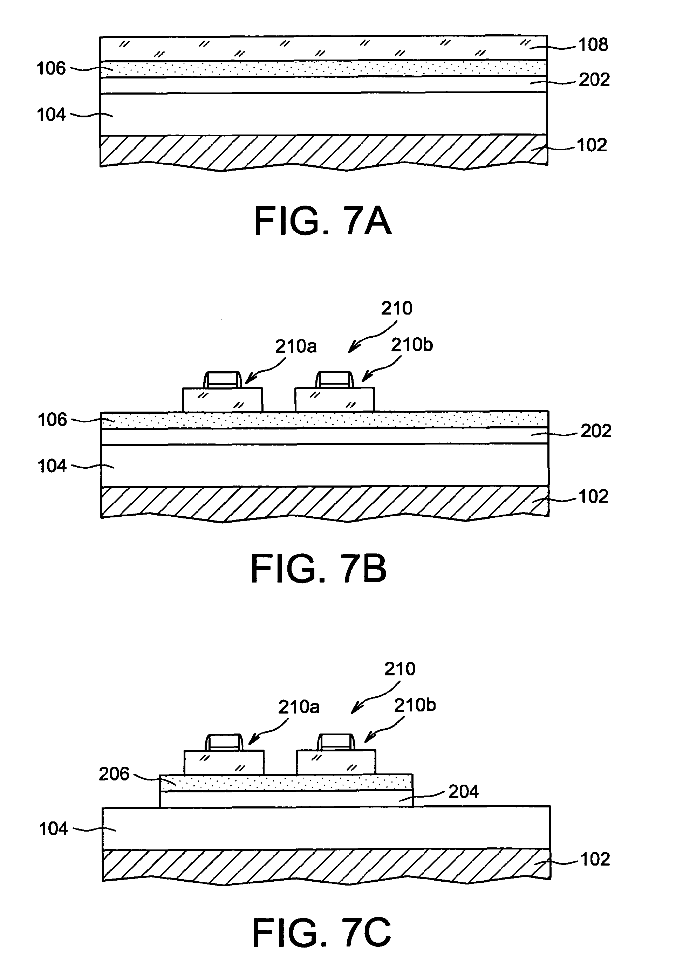

On se réfère maintenant aux figures 7A à 7E qui représentent les étapes d'un procédé de réalisation d'un dispositif imageur de rayonnement 200 selon un second mode de réalisation. Sur ces figures 7A à 7E, seule la réalisation d'une partie du dispositif imageur 200, correspondant à un pixel du dispositif imageur 200, est représentée.

Comme représenté sur la figure 7A, on réalise le dispositif imageur 200 à partir d'un substrat de type SOD comportant, de manière analogue au substrat utilisé pour réaliser le dispositif imageur 100 précédemment décrit, la couche arrière 102, la couche de diamant 104, la couche barrière 106 et la couche superficielle 108 de semi-conducteur.

Les couches 102, 104, 106 et 108 de ce substrat sont par exemple de dimensions et de nature similaires à ces mêmes couches précédemment décrites en liaison avec la figure 2A. Toutefois, le substrat SOD utilisé ici comporte également une couche électriquement conductrice 202, par exemple à base de tungstène et/ou de platine et/ou de titane et/ou d'un matériau carboné, par exemple du diamant dopé, et/ou de tout autre matériau électriquement conducteur ne se dégradant pas lorsqu'il est exposé aux hautes températures mises en jeu lors de la réalisation du circuit électronique du dispositif imageur 200, et d'épaisseur par exemple comprise entre environ 50 nm et 100 nm, disposée entre la couche de diamant 104 et la couche barrière 106. De plus, la couche de diamant 104 peut comporter une partie de nucléation se trouvant soit, de préférence, du côté de la couche arrière 102, soit du côté de la couche électriquement conductrice 202.

On réalise ensuite, dans des portions de la couche de semi-conducteur 108, des circuits électroniques formant, comme le circuit électronique 110 précédemment décrit en liaison avec le dispositif imageur 100, des circuits d'amplification et/ou de lecture du signal électrique qui sera collecté lorsqu'un rayonnement de photons et/ou des particules sera reçu par le dispositif imageur 200. Sur la figure 7B, deux transistors 210a, 210b de type CMOS du circuit électronique 210 sont représentés.

Chaque pixel du dispositif imageur 200 comporte au moins un circuit électronique similaire au circuit électronique 210. Comme pour le dispositif imageur 100, il est possible que le circuit électronique 210 comporte des éléments, tels que des transistors, de type PD-SOI ou FD-SOI si l'épaisseur de la couche de semi-conducteur 108 le permet (épaisseur par exemple inférieure à 1 μm).

Comme représenté sur la figure 7C, on grave ensuite la couche électriquement conductrice 202 et la couche barrière 106 selon un motif conforme à celui de l'électrode du pixel du dispositif imageur 200. Ainsi, sur l'exemple de la figure 7B, la portion restante 204 de la couche électriquement conductrice 202 forme une électrode du pixel du dispositif imageur 200 représenté.

Cette gravure forme également une portion restante 206 de la couche barrière 106 qui est superposée sur l'électrode 204. Le dimensionnement de l'électrode 204 peut être calculée de manière analogue à celle précédemment décrite en liaison avec le dispositif imageur 100, notamment en fonction de l'épaisseur de la couche de diamant 104 qui est elle-même fonction de la longueur d'absorption du diamant selon les particules que l'on souhaite détecter avec le dispositif imageur 200.

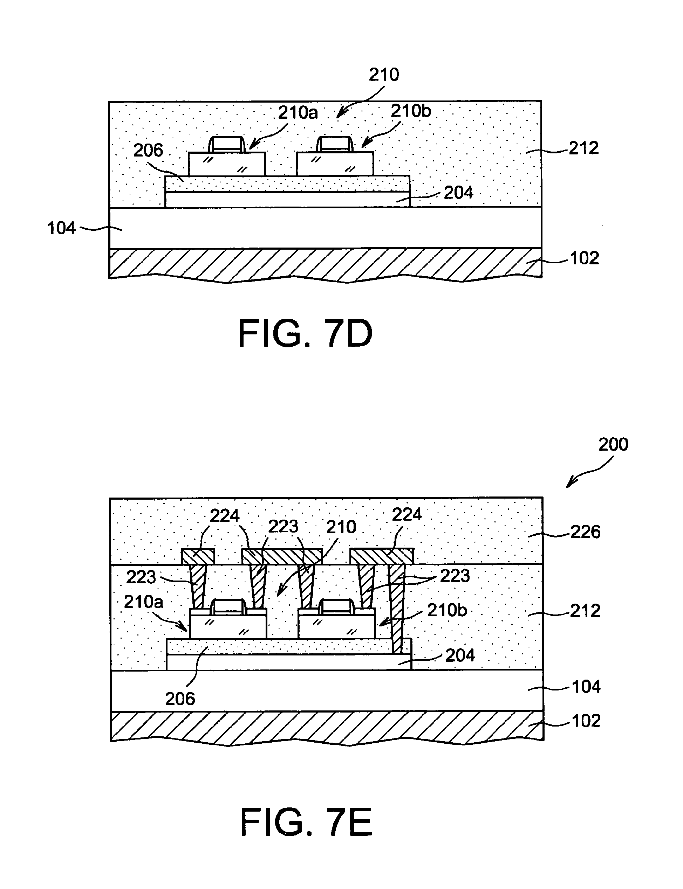

Comme représenté sur la figure 7D, une première couche de passivation 212 est ensuite déposée sur les éléments précédemment réalisés.

Comme pour le dispositif imageur 100, on réalise ensuite, à travers la couche de passivation 212, des vias traversant 223 permettant de contacter électriquement le circuit électronique 210 ainsi que l'électrode 204 (le via traverse alors également la portion restante 206 de la couche barrière), ainsi qu'une couche d'interconnexions électriques 224, par exemple à base d'aluminium et/ou de tout autre matériau électriquement conducteur adapté, permettant de relier électriquement l'électrode 204 au circuit électronique 210.

La couche d'interconnexions électriques 224 peut éventuellement être recouverte par une seconde couche de passivation 226 (figure 7E).

Par rapport au dispositif imageur 100, le dispositif imageur 200 comporte ici une électrode 204 disposée sous le circuit électronique 210. Ainsi, l'électrode 204 permet, outre son rôle d'électrode permettant au diamant de la couche 104 de jouer son rôle de transducteur, de protéger les circuits électroniques 210a, 210b du rayonnement visible car ce rayonnement peut être absorbé par l'électrode 204, notamment lorsque celle-ci est base de métal, ce qui évite d'avoir à rapporter un filtre supplémentaire au dispositif imageur 200 du côté de la couche arrière 102. Lorsque l'électrode 204 à base de semi-conducteur dopé, cette électrode peut avoir une épaisseur supérieure ou égale à environ quelques micromètres, par exemple 2 μm, afin que celle-ci réalise une absorption d'un rayonnement dans le domaine visible. De plus, cette superposition de l'électrode 204 et du circuit électronique 210 offre également un gain de place par rapport au dispositif imageur 100.

Les différentes variantes précédemment décrite en liaison avec le dispositif imageur 100 (électrode arrière formée par la couche arrière 102 ou une électrode arrière rapportée ultérieurement à la place de la couche arrière 102, circuit électronique d'amplification et/ou de lecture du signal au niveau de l'électrode) peuvent également s'appliquer au dispositif imageur 200.

**Revendications**

1.  Dispositif imageur (100, 150, 200) comportant plusieurs pixels, chaque pixel comprenant au moins :

    - une portion d'une couche de diamant (104) disposée entre une première (122, 204) et une seconde électrode (102), et apte à réaliser la transduction d'un rayonnement de photons et/ou de particules en un signal électrique,
- un circuit électronique (110, 210) d'amplification et/ou de lecture du signal électrique, relié électriquement au moins à la première électrode (122, 204) et réalisé dans une portion d'une couche de matériau semi-conducteur (108), cette couche (108) ayant une épaisseur inférieure ou égale à environ 1 μm et formant la couche superficielle d'un substrat de type SOD comportant également la couche de diamant (104) et une couche diélectrique (106, 206) disposée entre la couche de diamant (104) et le circuit électronique (110, 210).

2. Dispositif imageur (100, 150, 200) selon la revendication 1, dans lequel le circuit électronique (110, 210) comporte un ou plusieurs transistors (210a, 210b) de type PD-SOI ou FD-SOI.

3. Dispositif imageur (100, 150) selon l'une des revendications précédentes, dans lequel la première électrode (122) et le circuit électronique (110) sont disposés côte à côte au niveau d'une première face de la couche de diamant (104).

4. Dispositif imageur (100, 150) selon la revendication 3, dans lequel la première électrode (122) comporte des parois latérales au moins partiellement recouvertes par au moins un matériau diélectrique (118), lesdites parois latérales étant sensiblement perpendiculaires à une paroi inférieure de la première électrode (122) disposée contre la première face de la couche de diamant (104).

5. Dispositif imageur (100, 150) selon l'une des revendications 3 ou 4, comportant en outre des moyens de filtrage aptes à absorber des rayonnements de longueurs d'ondes comprises entre environ 380 nm et 780 nm disposés en regard d'une seconde face, opposée à la première face, de la couche de diamant (104).

6. Dispositif imageur (200) selon l'une des revendications 1 ou 2, dans lequel la première électrode (204) est disposée contre la couche de diamant (104), et entre le circuit électronique (210) et la couche de diamant (104).

7. Dispositif imageur (100, 150) selon l'une des revendications 3 à 5, dans lequel la couche de diamant (104) comporte une partie de nucléation se trouvant au niveau de sa première face, la première électrode (122) étant en partie disposée dans un creux formé dans la partie de nucléation de la couche de diamant (104).

8. Dispositif imageur (100, 150, 200) selon l'une des revendications 1 à 6, dans lequel la couche de diamant (104) comporte une partie de nucléation se trouvant au niveau d'une face opposée à celle contre laquelle est disposée la première électrode (122).

9. Dispositif imageur (100, 150, 200) selon l'une des revendications précédentes, comportant en outre au moins une couche de passivation (112, 212) recouvrant au moins le circuit électronique (110, 210) qui est relié électriquement à la première électrode (122, 204) par l'intermédiaire d'au moins une portion d'une couche d'interconnexions électriques (124, 224) disposée sur la couche de passivation (112, 212) et de vias traversant (123, 223) réalisés à travers au moins la couche de passivation (112, 212) et reliant électriquement la portion de la couche d'interconnexion électrique (124, 224) au circuit électronique (110, 210) et à la première électrode (122, 204).

10. Procédé de réalisation d'un dispositif imageur (100, 150, 200) comportant plusieurs pixels, comprenant, pour chaque pixel, au moins les étapes de :

- réalisation, dans une portion d'une couche de matériau semi-conducteur (108) cette couche ayant une épaisseur inférieure ou égale à environ 1 μm et formant la couche superficielle d'un substrat de type SOD comportant également une couche de diamant (104), d'un circuit électronique (110, 210) d'amplification et/ou de lecture de signal électrique, le substrat comportant également une couche diélectrique (106, 206) disposée entre la couche de diamant (104) et le circuit électronique (110, 210),
- réalisation d'une première électrode (122, 204) telle qu'une portion de la couche de diamant (104) soit disposée entre la première électrode (122, 204) et une seconde électrode (102), et soit apte à réaliser la transduction d'un rayonnement de photons et/ou de particules en un signal électrique,
- réalisation d'une liaison électrique (123, 124, 223, 224) au moins entre la première électrode (122, 204) et le circuit électronique (110, 210).

11. Procédé de réalisation selon la revendication 10, dans lequel la réalisation de la première électrode (122) est obtenue au moins par la mise en oeuvre des étapes suivantes :

a) dépôt d'une couche de passivation (112) recouvrant le circuit électronique (110) et la couche de matériau semi-conducteur (108),
b) réalisation, dans la couche de passivation (112) et la couche de matériau semi-conducteur (108), et à côté du circuit électronique (110), d'une cavité (114),

c) dépôt d'une couche diélectrique (118) au moins contre les parois de la cavité (114),

d) gravure d'une partie de la couche diélectrique (118) formant une paroi de fond de la cavité (114), révélant une partie (120) d'une première face de la couche de diamant (104),

e) réalisation d'une portion de matériau électriquement conducteur disposée dans la cavité (114), contre la première face de la couche de diamant (104), formant la première électrode (122).

12. Procédé de réalisation selon la revendication 10, dans lequel la réalisation de la première électrode (122) est obtenue au moins par la mise en oeuvre des étapes suivantes :

a) réalisation, dans la couche de matériau semi-conducteur (108), et à côté du circuit électronique (110), d'une cavité,

b) dépôt d'une couche diélectrique (118) au moins contre les parois de la cavité,

c) gravure d'une partie de la couche diélectrique (118) formant une paroi de fond de la cavité, révélant une partie (120) d'une première face de la couche de diamant (104),

d) réalisation d'une portion de matériau électriquement conducteur disposée dans la cavité, contre la première face de la couche de diamant (104), formant la première électrode (122),

e) dépôt d'une couche de passivation (112) recouvrant la première électrode (122), le circuit électronique (110) et la couche de matériau semi-conducteur (108).

13. Procédé de réalisation selon l'une des revendications 11 ou 12, dans lequel la couche diélectrique (106) est disposée entre la première face de la couche de diamant (104) et la couche de matériau semi-conducteur (108), et dans lequel l'étape d) de gravure ou l'étape a) de réalisation de la cavité réalise également la gravure d'une partie de ladite couche diélectrique (106) disposée au niveau de la paroi de fond de la cavité (114).

14. Procédé de réalisation selon l'une des revendications 11 à 13, dans lequel la couche de diamant (104) comporte une partie de nucléation se trouvant au niveau de sa première face, et dans lequel l'étape c) ou d) de gravure réalise également la gravure d'une partie de nucléation de la couche de diamant (104) se trouvant dans la cavité (114).

15. Procédé de réalisation selon la revendication 10, dans lequel le substrat de type SOD comporte une couche à base d'un matériau électriquement conducteur (202) disposée entre la couche de matériau semi-conducteur (108) et la couche de diamant (104), et dans lequel la réalisation de la première électrode (204) est obtenue au moins par la mise en oeuvre d'une gravure de la couche de matériau semi-conducteur (108) et de la couche de matériau électriquement conducteur (202) selon un motif conforme à celui de la première électrode (204), la première électrode (204) étant disposée contre la couche de diamant (104) et entre le circuit électronique (210) et la couche de diamant (104).

16. Procédé de réalisation selon la revendication 15, dans lequel la couche diélectrique (106) est disposée entre la couche de matériau électriquement conducteur (202) et la couche de matériau semi-conducteur (108), et dans lequel, au cours de la réalisation de la première électrode (204), la couche diélectrique (106) est également gravée selon un motif conforme à celui de la première électrode (204), telle que la première électrode (204) soit disposée contre la couche de diamant (104) et entre une portion restante (206) de la couche diélectrique (106) et la couche de diamant (104).

17. Procédé de réalisation selon l'une des revendications 15 ou 16, comportant en outre la mise en oeuvre, entre la réalisation de la première électrode (204) et la réalisation de la liaison électrique (223, 224), d'une étape de dépôt d'une couche de planarisation (212) recouvrant au moins le circuit électronique (210) et la première électrode (204).

18. Procédé de réalisation selon l'une des revendications 11 à 14 ou 17, dans lequel la réalisation de la liaison électrique (123, 124, 223, 224) entre la première électrode (122, 204) et le circuit électronique (110, 210) est obtenue au moins par la mise en oeuvre des étapes suivantes :

f) réalisation de vias traversant (123, 223) reliés électriquement à la première électrode (122, 204) et au circuit électronique (110, 210) à travers la couche de passivation (112, 212) et/ou la première électrode (122, 204),

g) réalisation d'une couche d'interconnexions électriques (124, 224) sur la couche de passivation (112, 212), telle qu'au moins une portion de la couche d'interconnexions électriques (124, 224) et les vias traversant (123, 223) relient électriquement la première électrode (122, 204) au circuit électronique (110, 210).

## Claims

1. Imaging device (100, 150, 200) including several pixels, each pixel including at least:

- a portion of a diamond layer (104) placed between a first (122, 204) and second electrode (102), and able to achieve transduction of photons and/or high energy particles radiation into an electric signal,

- an electronic circuit (110, 210) for amplification and/or reading of the electric signal, electrically connected to at least the first electrode (122, 204) and made in a portion of a semiconductor material layer (108), this layer (108) having a thickness lower than or equal to around 1 μm and forming the surface layer of an SOD type substrate, also including the diamond layer (104) and a dielectric layer (106, 206) placed between the diamond layer (104) and the electronic circuit (110, 210).

2. Imaging device (100, 150, 200) according to claim 1, in which the electronic circuit (110, 210) includes one or more transistors (210a, 210b) of PD-SOI or FD-SOI type.

3. Imaging device (100, 150) according to one of the preceding claims, in which the first electrode (122) and the electronic circuit (110) are placed side-by-side at the level of a first face of the diamond layer (104).

4. Imaging device (100, 150) according to claim 3, in which the first electrode (122) includes side walls at least partially covered by at least one dielectric material (118), said side walls being substantially perpendicular to a lower wall of the first electrode (122) placed against the first face of the diamond layer (104).

5. Imaging device (100, 150) according to one of claims 3 or 4, also including filtering means capable of absorbing radiation at wavelengths comprised between around 380 nm and 780 nm placed in front of a second face, opposite the first face, of the diamond layer (104).

6. Imaging device (200) according to one of claims 1 or 2, in which the first electrode (204) is placed against the diamond layer (104), and between the electronic circuit (210) and the diamond layer (104).

7. Imaging device (100, 150) according to one of claims 3 to 5, in which the diamond layer (104) includes a nucleation part located on its first face, the first electrode (122) being partially placed in a recess formed in the nucleation part of the diamond layer (104).

8. Imaging device (100, 150, 200) according to one of claims 1 to 6, in which the diamond layer (104) includes a nucleation part, located on one face opposite that against which the first electrode (122) is placed.

9. Imaging device (100, 150, 200) according to one of the preceding claims, also including at least one passivation layer (112, 212) covering at least the electronic circuit (110, 210), which is electrically connected to the first electrode (122, 204) through at least a portion of an electrical interconnections layer (124, 224) located on the passivation layer (112, 212) and through vias (123, 223) made through at least the passivation layer (112, 212) and electrically connecting the portion of the electrical interconnection layer (124, 224) to the electronic circuit (110, 210) and to the first electrode (122, 204).

10. Method for making an imaging device (100, 150, 200) including several pixels, including, for each pixel, at least the steps of:

   - making, in a portion of a semiconductor material layer (108), this layer (108) having a thickness lower than or equal to around 1 μm and forming the surface layer of an SOD type substrate also including a diamond layer (104), of an electronic circuit (110, 210) for amplification and/or reading of an electrical signal, the substrate also including a dielectric layer (106, 206) placed between the diamond layer (104) and the electronic circuit (110, 210),
   - making of a first electrode (122, 204) such that a portion of the diamond layer (104) is placed between the first electrode (122, 204) and a second electrode (102), and, which can make a transduction of photons and/or particles radiation into an electrical signal,
   - making of an electrical connection (123, 124, 223, 224) at least between the first electrode (122, 204) and the electronic circuit (110, 210).

11. Method according to claim 10, in which the making of the first electrode (122) is achieved by at least the implementation of the following steps:

   a) deposition of a passivation (112) layer covering the electronic circuit (110) and the semiconductor material layer (108),
   b) making, in the passivation layer (112) and the semiconductor layer (108), and next to the electronic circuit (110), of a cavity (114),
   c) deposition of a dielectric layer (118) at least against the walls of the cavity (114),
   d) etching of part of the dielectric layer (118) forming a bottom wall in the cavity (114), stripping part (120) of a first face of the diamond layer (104),
   e) making of a portion of an electrically conductive material placed in the cavity (114), against the first face of the diamond layer (104), forming the first electrode (122).

**12.** Method according to claim 10, in which the making of the first electrode (122) is achieved by at least the implementation of the following steps:

    a) making, in the semiconductor material layer (108), and next to the electronic circuit (110), of a cavity,
    b) deposition of a dielectric layer (118) at least against the walls of the cavity,
    c) etching of part of the dielectric layer (118) forming a bottom wall in the cavity, stripping part (120) of a first face of the diamond layer (104),
    d) making of a portion of an electrically conductive material placed in the cavity, against the first face of the diamond layer (104), forming the first electrode (122),
    e) deposition of a passivation layer (112) covering the first electrode (122), the electronic circuit (110), and the semiconductor material layer (108).

**13.** Method according to one of claims 11 or 12, in which the dielectric layer (106) is placed between the first face of the diamond layer (104) and the semiconductor material layer (108), and in which the step d) of etching or the step a) of making of the cavity also includes etching of a part of said dielectric layer (106) on the bottom wall of the cavity (114).

**14.** Method according to one of claims 11 to 13, in which the diamond layer (104) includes a nucleation part located on its first face, and in which step c) or d) of etching also includes etching of a nucleation part of the diamond layer (104) in the cavity (114).

**15.** Method according to claim 10, in which the SOD type substrate includes a layer (202) based on an electrical conductor material and placed between the semiconductor material layer (108) and the diamond layer (104), and in which the making of the first electrode (204) is achieved by at least the execution of etching of the semiconductor layer (108) and of the electrically conductive layer (202) according to a pattern consistent with that of the first electrode (204), the first electrode (204) being placed against the diamond layer (104) and between the electronic circuit (210) and the diamond layer (104).

**16.** Method according to claim 15, in which the dielectric layer (106) is placed between the electrical conductor material layer (202) and the semiconductor material layer (108), and in which, during the making of the first electrode (204), the dielectric layer (106) is also etched according to a pattern consistent with that of the first electrode (204), in such manner that the first electrode (204) is placed against the diamond layer (104) and between a remaining portion (206) of the dielectric layer (106) and the diamond layer (104).

**17.** Method according to one of claims 15 or 16, including additionally the implementation, between the making of the first electrode (204) and the making of the electrical connection (223, 224), of a step of depositing a planarization layer (212) covering at least the electronic circuit (210) and the first electrode (204).

**18.** Method according to one of claims 11 to 14 or 17, in which the making of the electrical connection (123, 124, 223, 224) between the first electrode (122, 204) and the electronic circuit (110, 210) is achieved at least by implementation of the following steps:

    f) making of through vias (123, 223) electrically connected to the first electrode (122, 204) and to the electronic circuit (110, 210) through the passivation layer (112, 212) and/or the first electrode (122, 204),
    g) making of an electrical interconnection layer (124, 224) on the passivation layer (112, 212), so that at least one portion of the electrical interconnection layer (124, 224) and the through vias (123, 223) electrically connect the first electrode (122, 204) to the electronic circuit (110, 210).

**Patentansprüche**

**1.** Bilderzeugungsvorrichtung (100, 150, 200), umfassend mehrere Pixel, wobei jedes Pixel wenigstens umfasst:

    - einen Abschnitt einer Diamantschicht (104), welche zwischen einer ersten (122, 204) und einer zweiten Elektrode (102) angeordnet und dazu geeignet ist, die Umwandlung einer Strahlung von Photonen oder/und Teilchen in ein elektrisches Signal umzusetzen,
    - einen elektronischen Schaltkreis (100, 110) zur Verstärkung oder/und zum Auslesen des elektrischen Signals, der elektrisch wenigstens mit der ersten Elektrode (122, 204) verbunden ist, und der in einem Abschnitt einer Schicht aus halbleitendem Material (108) hergestellt ist, wobei diese Schicht (108) eine Dicke aufweist, die kleiner oder gleich ungefähr 1 $\mu$m ist und die Oberflächenschicht eines Substrats vom SOD-Typ bildet, welches ebenfalls die Diamantschicht (104) und eine dielektrische Schicht (106, 206) umfasst, welche zwischen der Diamantschicht (104) und dem elektronischen Schaltkreis (110, 210) angeordnet ist.

**2.** Bilderzeugungsvorrichtung (100, 150, 200) nach Anspruch 1, wobei der elektronische Schaltkreis (110, 210) einen oder mehrere Transistoren (210a, 210b) vom Typ PD-SOI oder FD-SOI umfasst.

3. Bilderzeugungsvorrichtung (100,150) nach einem der vorhergehenden Ansprüche, wobei die erste Elektrode (122) und der elektronische Schaltkreis (110) nebeneinander auf Höhe einer ersten Oberfläche der Diamantschicht (104) angeordnet sind.

4. Bilderzeugungsvorrichtung (100, 150) nach Anspruch 3, wobei die erste Elektrode (122) Seitenwände umfasst, welche wenigstens teilweise durch wenigstens ein dielektrisches Material (118) abgedeckt sind, wobei die Seitenwände im Wesentlichen senkrecht zu einer unteren Wand der ersten Elektrode (122) verlaufen, welche an der ersten Oberfläche der Diamantschicht (104) angeordnet ist.

5. Bilderzeugungsvorrichtung (100, 150) nach einem der Ansprüche 3 oder 4, weiter umfassend ein Filtermittel, welches dazu geeignet ist, Strahlungen mit Wellenlängen zwischen ungefähr 380 nm und 780 nm zu absorbieren, und das gegenüber von einer zweiten Oberfläche der Diamantschicht (104) angeordnet ist, welche der ersten Oberfläche gegenüberliegt.

6. Bilderzeugungsvorrichtung (200) nach einem der Ansprüche 1 oder 2, wobei die erste Elektrode (204) an der Diamantschicht (104) angeordnet ist, und zwischen dem elektronischen Schaltkreis (210) und der Diamantschicht (104).

7. Bilderzeugungsvorrichtung (100, 150) nach einem der Ansprüche 3 bis 5, wobei die Diamantschicht (104) einen Nukleationsteil umfasst, welcher sich auf Höhe ihrer ersten Oberfläche befindet, wobei die erste Elektrode (122) teilweise in einer Vertiefung angeordnet ist, welche in dem Nukleationsteil der Diamantschicht (104) ausgebildet ist.

8. Bilderzeugungsvorrichtung (100, 150, 200) nach einem der Ansprüche 1 bis 6, wobei die Diamantschicht (104) einen Nukleationsteil umfasst, der sich auf Höhe einer Oberfläche befindet, die derjenigen gegenüberliegt, an welcher die erste Elektrode (122) angeordnet ist.

9. Bilderzeugungsvorrichtung (100, 150, 200) nach einem der vorhergehenden Ansprüche, weiterhin umfassend wenigstens eine Passivierungsschicht (112, 212), welche wenigstens den elektronischen Schaltkreis (110, 210) abdeckt, der elektrisch mit der ersten Elektrode (122, 204) verbunden ist, vermittels von wenigstens einem Abschnitt von einer Schicht von elektrischen Verbindungen (124, 224), welche auf der Passivierungsschicht (112, 212) angeordnet ist und von Durchkontaktierungen (123, 223), die durch wenigstens die Passivierungsschicht (112, 212) hindurch ausgeführt sind und die den Abschnitt der elektrischen Verbindungsschicht (124, 224) elektrisch mit dem elektronischen Schaltkreis (110, 210) und mit der ersten Elektrode (122, 204) verbinden.

10. Herstellungsverfahren für eine Bilderzeugungsvorrichtung (100, 150, 200), welche mehrere Pixel umfasst, umfassend, für jedes Pixel, wenigstens die Schritte:

- Herstellung, in einem Abschnitt einer Schicht aus halbleitendem Material (108), wobei diese Schicht eine Dicke aufweist, die kleiner oder gleich ungefähr 1 $\mu$m ist und die Oberflächenschicht von einem Substrat vom SOD-Typ bildet, das ebenfalls eine Diamantschicht (104) umfasst, von einem elektronischen Schaltkreis (110, 210) zur Verstärkung oder/und zum Auslesen eines elektrischen Signals, wobei das Substrat weiterhin eine dielektrische Schicht (106, 206) umfasst, die zwischen der Diamantschicht (104) und dem elektronischen Schaltkreis (110, 210) angeordnet ist,
- Herstellen von einer ersten Elektrode (122, 204), so dass ein Abschnitt der Diamantschicht (104) zwischen der ersten Elektrode (122, 204) und einer zweiten Elektrode (102) angeordnet und dazu geeignet ist, die Umwandlung von einer Strahlung von Photonen oder/und von Teilchen in ein elektrisches Signal durchzuführen,
- Herstellen einer elektrischen Verbindung (123, 124, 223, 224) wenigstens zwischen der ersten Elektrode (122, 204) und dem elektronischen Schaltkreis (110, 210).

11. Herstellungsverfahren nach Anspruch 10, wobei die Herstellung der ersten Elektrode (122) wenigstens durch die Durchführung der folgenden Schritte erhalten wird:

a) Aufbringen einer Passivierungsschicht (112), welche den elektronischen Schaltkreis (110) und die Schicht aus halbleitendem Material (108) abdeckt,
b) Herstellen einer Kavität (114) in der Passivierungsschicht (112) und der Schicht aus halbleitendem Material (108) und neben dem elektronischen Schaltkreis (110),
c) Aufbringen einer dielektrischen Schicht (118) wenigstens an den Wänden der Kavität (114),
d) Ätzen von einem Teil der dielektrischen Schicht (118), der eine Bodenwand der Kavität (114) bildet, wobei ein Teil (120) einer ersten Oberfläche der Diamantschicht (104) freigelegt wird,
e) Herstellen von einem Abschnitt aus elektrisch leitendem Material, der in der Kavität (114) an der ersten Oberfläche der Diamantschicht (104) angebracht wird, wodurch die erste Elektrode (122) gebildet wird.

12. Herstellungsverfahren gemäß Anspruch 10, wobei die Herstellung der ersten Elektrode (122) wenigstens durch die Durchführung der folgenden Schritte erhalten wird:

   a) Herstellen einer Kavität in der Schicht aus halbleitendem Material (108) und neben dem elektronischen Schaltkreis (110),
   b) Aufbringen einer dielektrischen Schicht (118) wenigstens an den Wänden der Kavität,
   c) Ätzen von einem Teil der dielektrischen Schicht (118), der eine Bodenwand der Kavität bildet, wodurch ein Teil (120) von einer ersten Oberfläche der Diamantschicht (104) freigelegt wird,
   d) Herstellen von einem Abschnitt aus elektrisch leitendem Material, der in der Kavität an der ersten Oberfläche der Diamantschicht (104) angeordnet wird, wodurch die erste Elektrode (122) gebildet wird,
   e) Aufbringen einer Passivierungsschicht (112), welche die erste Elektrode (122), den elektronischen Schaltkreis (110) und die Schicht aus halbleitendem Material (108) abdeckt.

13. Herstellungsverfahren nach einem der Ansprüche 11 oder 12, wobei die dielektrische Schicht (106) zwischen der ersten Oberfläche der Diamantschicht (104) und der Schicht aus halbleitendem Material (108) angeordnet wird, und wobei der Schritt d) des Ätzens oder der Schritt a) der Herstellung der Kavität weiterhin das Ätzen von einem Teil der dielektrischen Schicht (106) umsetzt, der auf Höhe der Bodenwand der Kavität (114) angeordnet ist.

14. Herstellungsverfahren nach einem der Ansprüche 11 bis 13, wobei die Diamantschicht (104) einen Nukleationsteil umfasst, der sich auf Höhe ihrer ersten Oberfläche befindet, und wobei der Schritt c) oder d) des Ätzens ebenfalls das Ätzen von einem Nukleationsteil der Diamantschicht (104) umfasst, der sich in der Kavität (114) befindet.

15. Herstellungsverfahren nach Anspruch 10, wobei das Substrat vom SOD-Typ eine Schicht auf Grundlage von einem elektrisch leitenden Material (202) umfasst, die zwischen der Schicht aus halbleitendem Material (108) und der Diamantschicht (104) angeordnet ist, und wobei das Herstellen der ersten Elektrode (204) wenigstens durch die Ausführung von einem Ätzen der Schicht aus halbleitendem Material (108) und der Schicht aus elektrisch leitendem Material (202) entsprechend einem Muster erhalten wird, welches zu demjenigen der ersten Elektrode (204) konform ist, wobei die erste Elektrode (204) an der Diamantschicht (104) und zwischen dem elektronischen Schaltkreis (210) und der Diamantschicht (104) angeordnet ist.

16. Herstellungsverfahren nach Anspruch 15, wobei die dielektrische Schicht (106) zwischen der Schicht aus elektrisch leitendem Material (202) und der Schicht aus halbleitendem Material (108) angeordnet ist, und wobei während der Herstellung der ersten Elektrode (204) die dielektrische Schicht (106) weiterhin entsprechend einem Muster geätzt wird, welches zu demjenigen der ersten Elektrode (204) konform ist, so dass die erste Elektrode (204) an der Diamantschicht (104) und zwischen einem übrigen Abschnitt (206) der dielektrischen Schicht (106) und der Diamantschicht (104) angeordnet ist.

17. Herstellungsverfahren nach einem der Ansprüche 15 oder 16, weiterhin umfassend die Durchführung eines Schritts des Aufbringens einer Planarisierungsschicht (212), welche wenigstens den elektronischen Schaltkreis (210) und die erste Elektrode (204) bedeckt, zwischen der Herstellung der ersten Elektrode (204) und der Herstellung der elektrischen Verbindung (223, 224).

18. Herstellungsverfahren nach einem der Ansprüche 11 bis 14 oder 17, wobei die Herstellung der elektrischen Verbindung (123, 124, 223, 224) zwischen der ersten Elektrode (122, 204) und dem elektronischen Schaltkreis (110, 210) wenigstens durch Durchführung der folgenden Schritte erhalten wird:

   f) Herstellung von Durchkontaktierungen (123, 223), welche elektrisch mit der ersten Elektrode (122, 204) und mit dem elektronischen Schaltkreis (110, 210) verbunden sind, durch die Passivierungsschicht (112, 212) oder/und die erste Elektrode (122, 204) hindurch,
   g) Herstellung einer Schicht von elektrischen Verbindungen (124, 224) auf der Passivierungsschicht (112, 212), so dass wenigstens ein Abschnitt der Schicht von elektrischen Verbindungen (124, 224) und die Durchkontaktierungen (121, 223) die erste Elektrode (122, 204) mit dem elektronischen Schaltkreis (110, 210) elektrisch verbinden.

**FIG. 1**

**FIG. 3**

108 —     — 106

104 —     — 102

Z

X

Y

# FIG. 2A

110

108 —     — 106

104 —     — 102

# FIG. 2B

112

110

108 —     — 106

104 —     — 102

# FIG. 2C

**FIG. 2D**

**FIG. 2E**

FIG. 2F

FIG. 2G

FIG. 2H

FIG. 4

FIG. 5

FIG. 6

FIG. 7A

FIG. 7B

FIG. 7C

# FIG. 7D

# FIG. 7E

**EP 2 357 496 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **R. STONE et al.** CVD Diamond Pixel Development. *IEEE TRANSACTIONS ON NUCLEAR SCIENCE,* Juin 2002, vol. 49 (3

- **LAGOMARSINO S. et al.** New perspectives of the Silicon-On-Diamond material. *9th International conference on large scale applications and radiation hardness of semiconductor materials, Florence,* 30 Septembre 2009

**24**